Europäisches Patentamt

European Patent Office

Office européen des brevets

(11) Veröffentlichungsnummer: **0 319 851**
**A1**

## (12) EUROPÄISCHE PATENTANMELDUNG

(21) Anmeldenummer: 88120101.6

(22) Anmeldetag: 02.12.88

(51) Int. Cl.⁴: **H03L 7/08 , H03L 7/18 , H04H 1/00 , H03B 27/00**

(30) Priorität: 08.12.87 DE 3741423

(43) Veröffentlichungstag der Anmeldung:
14.06.89 Patentblatt 89/24

(84) Benannte Vertragsstaaten:
**DE FR GB IT SE**

(71) Anmelder: **Licentia Patent-Verwaltungs-GmbH**
**Theodor-Stern-Kai 1**
**D-6000 Frankfurt/Main 70(DE)**

(72) Erfinder: **Kriegge, Gerd-Rudolf, Dipl.-Ing.**
**Sollmannweg 7**
**D-1000 Berlin 47(DE)**

(74) Vertreter: **Schulze, Harald Rudolf, Dipl.-Ing. et al**
**Licentia Patent-Verwaltungs-GmbH**
**Theodor-Stern-Kai 1**
**D-6000 Frankfurt/Main 70(DE)**

(54) Digitale Phaseneinstellung für digital generierte Signale.

(57) Die Erfindung betrifft eine Anordnung zum Einstellen der Phase eines oder mehrerer digital generierter Signale mit einem vorzugsweise digitalen Phasenstellglied (5, 6, 11, 12), bei der die Einstellung der Phase digital erfolgt. Die Phase ist zwischen 0 und $m2\pi$ in Einheiten von $2\pi/n$ oder Bruchteilen davon beliebig einstellbar mit m, n gleich ganzen positiven Zahlen und $m \geq 1$ und $n \geq 2$.

FIG.1

## Digitale Phaseneinstellung für digital generierte Signale

Die Erfindung betrifft eine Anordnung zum Einstellen der Phase eines digital generierten Signals mit einem Phasenstellglied gemäß Oberbegriff des Patentanspruchs 1.

Anordnungen dieser Art werden beispielsweise in Codern oder in Generatoren eingesetzt, bei denen ein digital generiertes Signal mit einem Referenzsignal in einer bestimmten festen oder einstellbaren Phasenbeziehung stehen muß. Dies trifft insbesondere auf RDS ("Radio-Daten-System")-Coder und Verkehrsfunkcoder zu sowie auf Sendervorstufen.

Es wurde bereits eine analog arbeitende Phasenregelung vorgeschlagen, bei der die Phase des digital generierten Analogsignals mit der eines Referenzsignals in einem Phasenvergleicher verglichen wird, der aus dem Vergleich ein Korrektursignal ableitet, mit dem die gewünschte Phasenbeziehung eingestellt bzw. geregelt wird. Insbesondere bei erhöhten Anforderungen an die Reproduzierbarkeit und zeitliche Konstanz der Phasenbeziehung ergeben sich bei dieser analogen Lösung häufig Probleme, die ihre Ursache in den prinzipiell vorhandenen bauteil- bzw. schaltungstechnisch bedingten Toleranzen in der Analog-Schaltungstechnik haben und die in der Regel nur mit erheblichen Aufwand umgangen werden können.

Die Aufgabe der Erfindung besteht darin, eine Anordnung der eingangs genannten Art zu schaffen, die ein Höchstmaß an Reproduzierbarkeit und zeitlicher Konstanz in der Phaseneinstellung des digital generierten Signals gewährleistet.

Die erfindungsgemäße Lösung dieser Aufgabe ist im Patentanspruch 1 beschrieben. Die Unteransprüche enthalten vorteilhafte Aus- und Weiterbildungen der Erfindungen sowie bevorzugte Anwendungen der Erfindung.

Die erfindungsgemäße Lösung besteht darin, daß die Einstellung der Phase digital erfolgt. In einer vorteilhaften Ausbildung ist die Phase dabei zwischen 0 und $m \cdot 2\pi$ in Einheiten von $2\pi/n$ oder Bruchteile davon beliebig einstellbar, wobei $m$ und $n$ ganze positive Zahlen sind mit $m \geq$ und $n \geq 2$. Die Vorteile der Erfindung sind vor allem in der hohen Reproduzierbarkeit und Genauigkeit der Phaseneinstellung sowie in deren hohen zeitlichen Konstanz zu sehen. Weitere Vorteile der Erfindungen werden weiter unten beschrieben.

Im folgenden wird die Erfindung im Zusammenhang mit einem RDS-Coder anhand der Figuren näher erläutert. Die Erfindung ist jedoch nicht -wie eingangs bereits vermerkt-auf diesen Anwendungsfall beschränkt, sondern kann ganz allgemein in der Signalerzeugung verwendet werden und eignet sich insbesondere für Coder oder Generatoren, bei denen ein digital generiertes Signal mit einem Referenzsignal in einer bestimmten oder einstellbaren Phasenbeziehung stehen muß.

Unter RDS oder Radio-Daten-System versteht man einen neuen Dienst im UKW-Rundfunk, der eine zum normalen Rundfunkprogramm kompatible (d. h. unhörbare) Übertragung von Zusatzinformationen ermöglicht wie z. B. Abstimmhilfen (Programmkettenkennung, Name der Programmkette, Programmart, Verkehrsfunkkennung, alternative Frequenzen usw.), Schaltsignale (Verkehrsdurchsagekennung, Decodersteuerung, Musik/Sprachekennung, Programmbeitragskennung usw.) und andere Information (Radiotext, Informationen über andere Ketten, Uhrzeit/Datum usw.).

Weitere Einzelheiten über dieses neue System sind in dem Fachartikel "RDS - Ein neuer Dienst im UKW-Rundfunk" von Franz Stollenwerk in NTZ 40 (1987)5, S. 346-351 beschrieben.

Der RDS-Coder muß ein komplexes Signal generieren. Dieses enthält einen 1187.5 Hz Datenstrom, der differential- und biphase-codiert auf 57 kHz aufmoduliert (Zweiseitenband ohne Träger) und mit einer Filterfunktion beaufschlagt wird, die ein vorgeschriebenes Frequenz-Spektrum gewährleistet.

Ein im RDS-Coder integrierter Verkehrsfunk-Coder generiert einen 57 kHz Träger, auf dem Kennungssignale aufmoduliert sind.

Das Verkehrsfunk- und das RDS-Signal werden im RDS-Coder addiert, wobei die Teilsignale eine Phasenbeziehung von exakt 90° ($\pi/2$) haben müssen.

Dies ist in der EBU Tech. 3244-E, sowie den technischen Pflichtenheften der ARD 5/3.8 (Coder für Radio-Daten-System) und 5/3.6 (Verkehrsrundfunk-Coder) festgelegt.

Das Ausgangs-Signal des RDS-Coders muß in einer festen Phasenbeziehung zur dritten Harmonischen eines extern eingespeisten 19 kHz Pilottons S1 stehen. Der Phasenwinkel muß beliebig einstellbar sein, also zwischen 0 und $m \cdot 2\pi$ mit $m \geq 1$.

Das RDS-Signal ist digital im Speicher (PROM, EPROM, EEPROM. RAM) als sequenzielle Folge von Stütz- oder Abtastwerten abgelegt und wird abhängig vom RDS-Datenstrom ausgelesen. Diese digitalen Werte werden von einem Digital-Analog-Wandler in ein analoges Signal gewandelt. Dadurch werden diskrete toleranzbehaftete Baugruppen, wie ein Zweiseitenband-Modulator und ein schmalbandiges Filter nicht benötigt.

Das Verkehrsfunk-Signal (57 kHz-Träger) wird ebenfalls aus einem Speicher ausgelesen und analog gewandelt.

Das Verfahren der sequenziellen Auslegung eines digitalen Speichers mit anschließender Digital/Analog-Wandlung der ausgelesenen Werte ist an sich bekannt.

Weiterhin ist an sich bekannt, daß zur Generierung eines Signals durch digitale Stützwerte mindestens die doppelte Auslesefrequenz (Abtastfrequenz) gegenüber der Signalfrequenz gewählt werden muß. Es ist sehr vorteilhaft, wenn das Verhältnis zwischen Auslesefrequenz (Abtastfrequenz) und zu generierender Signalfrequenz noch viel höher als 2 ist. In diesem Fall ist der Filteraufwand zur Entfernung der Auslesefrequenz-Reste im gewandelten Analog-Signal viel geringer und bezüglich der Toleranz erheblich unkritischer.

Zur Auslesung des Speichers müssen dessen Adreßeingänge binär durchgezählt werden. Das Binärwort bestimmt in seinem niederwertigen Anteil, welcher Abtastwert innerhalb einer 57 kHz-Periode gerade ausgelesen wird (Phasenwinkel oder kurz "Phase"). Applikationsbedingt werden auch die höherwertigen Anteile des Binärwortes verwendet. Diese bestimmen, welche der vielen im Speicher abgelegten 57 kHz-Perioden gerade ausgelesen werden.

Zur automatischen Einstellung und Konstanthaltung der gewählten Phasenlage wird ein an sich bekanntes Phasenstellglied ("PLL-Schaltung") verwendet, das vorzugsweise selbst digital arbeitet. Denkbar ist aber auch der Einsatz eines analog arbeitenden Phasenstellglieds. Hier würde zwar die Phaseneinstellung (der Einstellwert) erfindungsgemäß digital generiert, jedoch müßten diese digitalen erzeugten Signale dann über einen Digital/Analog-Wandler dem Phasenstellglied zugeführt werden.

Für die Auslesung eines Speichers, der die zu generierende Zeitfunktion (z. B. das RDS-Signal) in Form digitaler Stützwerte enthält, müssen die Adreßleitungen des Speichers binär, sequentiell und wiederholt durchgezählt werden. Der Startzeitpunkt des Zähldurchlaufs innerhalb einer Periode der zu generierenden Zeitfunktion (z. B. 57 kHz) bestimmt deren Phasenlage gegenüber einem Referenz-Signals. Die erfindungsgemäße Schaltung muß in diesem Fall dafür sorgen, daß diese Phasenlage in möglichst geringer Schrittweite in einem Bereich von 0 bis m•2$\pi$ gegenüber dem Referenz-Signal (3. Harmonische von 19 kHz = 57 kHz) einstellbar ist.

Im folgenden wird die Erfindung anhand der Figuren näher erläutert.

In den Figuren sind vorteilhafte Ausführungsformen der erfindungsgemäßen Lösung beschrieben. Es zeigen:

FIG. 1 eine vorteilhafte Ausführungsform der erfindungsgemäßen Lösung zur digitalen Phaseneinstellung für ein erstes digital generiertes Signal mit genauer und reproduzierbarer Phasenbeziehung zu einem Referenzsignal

FIG. 2 eine vorteilhafte Weiterbildung der in FIG. 1 beschriebenen Ausführungsform zur digitalen Phaseneinstellung für ein (oder mehreres) weiteres digital generiertes Signal mit genauer und reproduzierbarer Phasenbeziehung zu dem ersten digital generierten Signal.

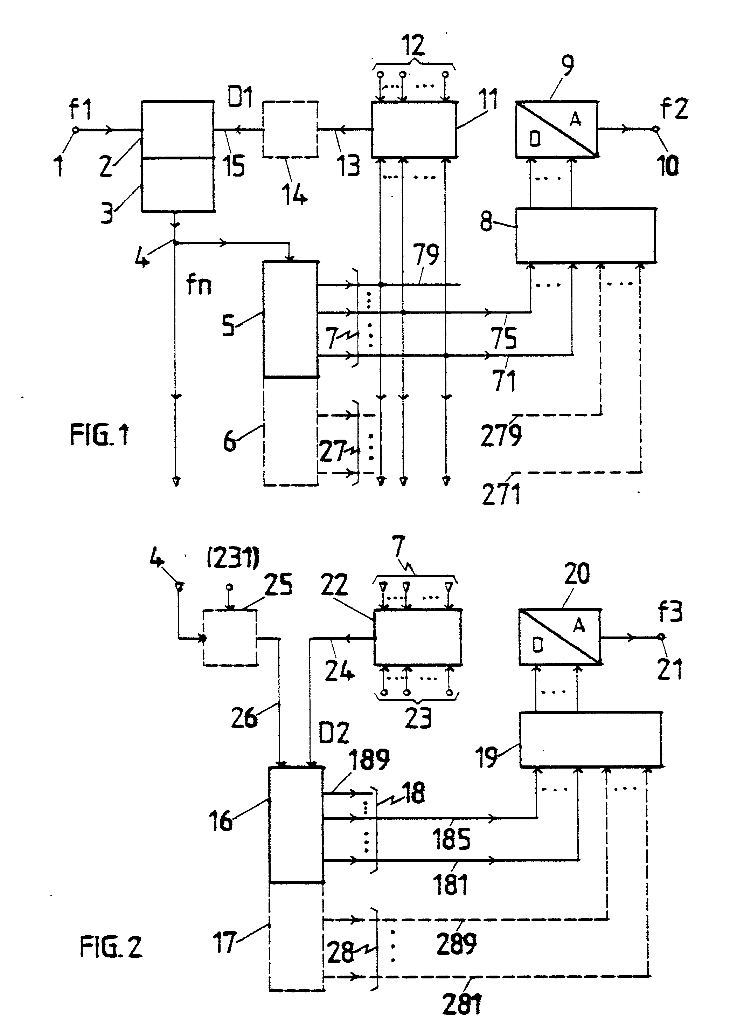

Gemäß Figur 1 erzeugt ein spannungskontrollierter Oszillator (VCO) 3 einer PLL-Schaltung 2,3 eine Frequenz fn, die n-mal so hoch ist wie die Frequenz des zu generierenden Signals mit der Frequenz f2.

Damit ergibt sich eine Schrittweite der Phaseneinstellung = 2$\pi$·n Grad.

Die Frequenz fn wird über die Verbindungsleitung 4 einem binären Zähler 5 mit parallel Ausgängen 71...75...79 zugeführt. Applikationsbedingt kann dem Zähler 5 ein binärer Zähler 6 mit parallelen Ausgängen 271...279 folgen. Die Aufteilung in 5 und 6 nimmt nicht Bezug auf die Bauelemente, sondern auf die Funktion. Zähler 5 liefert ein niederwertige Binärwort 7, welches die vollständige Phasenwinkel-Information enthält und damit bestimmt, welcher der in einen Speicher 8 abgespeicherten Abtastwert einer Periode des Ausgangs-Signals f2 gerade aus dem Speicher 8 ausgelesen wird. Dieses Binärwort wird zyklisch durchgezählt.

Je nach Anzahl der Abtastwerte des zu generierenden Signals f2, die pro Periode im Speicher 8 abgelegt sind, werden mehr oder weniger viele der parallelen Ausgänge 71...-75...79 des Zählers 5 an die Adresseingänge des Speichers 8 gelegt. Dabei kann es in bestimmten Fällen von Vorteil sein, nur den höherwertigen Anteil (71...75) des Binärwortes 7 vom Zähler 5 allein zu verwenden. Dies liegt z.B. dann, vor wenn die Auflösung der Phaseneinstellung höher ist als die Auflösung einer Periode des abgespeicherten Signals ( = Anzahl der Abtastwerte pro Periode). In diesem Fall wird der niederwertige Teil des Binärwortes 7 nicht dem Speicher 8, sondern nur dem Komparator 11 zugeführt.

In besonderen Applikationen wie z.B. dem RDS-Coder können das Binärwort 27 des Zählers 6 sowie andere Auswahlsignale an die Adresseingänge des Speichers 8 angeschlossen werden. Damit wird bestimmt. welche (57 kHz-) Periode aus dem Speicher 8 gerade ausgelesen wird.

Die durch die Adreßeingänge des Speichers 8 angewählten digitalen Stützwerte werden in an sich bekannter Weise auf einen Digital-Analog-Wandler 9 gegeben und von diesem in das analoge Ausgangssignal f2 umgewandelt, das am Ausgang 10 abgeifbar ist.

Das vom Zähler 5 gelieferte Binärwort 7, welches die Phasenwinkelinformation enthält, wird dem (Magnitude-) Komparator 11 zugeführt. Dieser vergleicht das Binärwort 7 bitweise mit einem ebenfalls am Komparator 11 angelegten Vorgabewort 12, welches die vollständige Information über die einzustellende Phase enthält. Wenn bei zyklischem Durchzählen des Binärwortes 7 beide Worte übereinstimmen, gibt der Komparator 11 jedes mal ein Signal D1 ab, welches dem Phasenvergleicher 2 der PLL-Schaltung 2,3 über die Leitung 13, 15 zugeführt wird.

Der Phasenvergleicher 2 der PLL-Schaltung vergleicht die Phasenlage des Referenz-Signals der Frequenz f1 mit Phasenlage des vom Magnitude-Komparators 11 gelieferten zyklischen Signals D1 und regelt den VCO 3 entsprechend nach.

Im besonderen Anwendungsfall, wo das Ausgangssignal auf eine Harmonische des Referenz-Signals mit der k-fachen Frequenz des Referenzsignals f1 synchronisiert werden muß, wird vorteilhaft zwischen Magnitude-Komparator 11 und Phasenvergleicher 2 ein Frequenzteiler 14(:k) eingesetzt.

Bei dem RDS-Coder z. B wird das Ausgangssignal f2 (57 kHz) auf die Harmonische des Referenz-Signals f1 mit der 3-fachen Frequenz des Referenz-Signals f1 synchronisiert (19 kHz). In diesem Fall kommt ein Frequenzteiler 14 mit einem Teilungsverhältnis ":3" zum Einsatz.

Bei der digitalen Phaseneinstellung für ein weiteres digital generiertes Signal der Frequenz f3 mit reproduzierbarer genauer Phasenbeziehung zu dem ersten Signal der Frequenz f2 wird gemäß Figur 2 das Taktsignal des VCO 3 mit der Frequenz fn über die Verbindungsleitung 4, 26 einem Zähler 16 mit parallelen Ausgängen 181...185...189 zugeführt. Dieser Zähler liefert das Binärwort 18. Dieses bestimmt, welcher Abtastwert einer Periode des zu generierenden Signals f3 gerade aus einem weiteren Speicher 19 ausgelesen wird. Dieses Binärwort wird zyklisch durchgezählt.

Je nach Anzahl der Abtastwerte des zu generierenden Signals, die pro Periode im Speicher 19 abgelegt sind, werden mehr oder weniger viele der parallelen Anschlüsse 181...-185...189 des Zählers 16 an die Adresseingänge des Speichers 19 gelegt. Dabei kann es in bestimmten Fällen vorteilhaft sein, nur höherwerte Anteile 181...185 des Binärwortes 18 vom Zähler 16 allein zu verwenden. Dies liegt z.B. dann vor, wenn die Auflösung der Phaseneinstellung höher ist als die Auflösung einer Periode des abgespeicherten Signals (= Anzahl der Abtastwerte pro Periode). In diesem Fall wird der niederwertige Teil des Binärwortes 18 nicht dem Speicher 19 zugeführt.

In besonderen Applikationen wird das höherwerte Binärwort 28 eines weiteren Zählers 17 mit parallelen Ausgängen 281...289 an den Speicher 19 angeschlossen. Damit wird bestimmt, welche Periode(n) aus dem Speicher gerade ausgelesen wird (werden).

Die durch die Adreßeingänge des Speichers 19 angewählten digitalen Stützwerte werden auf einen weiteren Digital/Analog-Wandler 20 gegeben und von diesem in an sich bekannter Weise in das analoge Ausgangssignal f3 umgewandelt, das am Ausgang 21 abgreifbar ist.

Der (Magnitude-)Komparator 22 vergleicht das Binärwort 7 bitweise mit einem ebenfalls am Komparator 22 angelegten binären Vorgabewort 23, welches die Informationen über die einzustellende Phase enthält. Wenn beim zyklischen Durchzählen des Binärwortes 7 beide Worte übereinstimmen, gibt der Komparator jedesmal ein Signal D2 über die Verbindungsleitung 24 ab, welches den Zähler 16 rücksetzt bzw. neu startet.

Das eingestellte Vorgabewort 23 bestimmt damit, bei welcher Phasenlage des Ausgangs-Signals 10 das Ausgangs-Signal 21 eine neue Periode beginnt. Damit wird die Phasen-Differenz beider Ausgangs-Signale zueinander festgelegt.

In der praktischen Anwendung des RDS-Coders sind hier 90° ($\pi/2$) bzw. 0° eingestellt. Dazu muß das Teilerverhältnis n durch 4 teilbar sein. Es kann aber auch jeder andere Winkel im Auflösungsraster eingestellt werden.

Mit Einbeziehung einer einstellbaren Invertierung 25 des Taktes für den Zähler ist es sogar in einer vorteilhaften Weiterbildung möglich, die Schrittweite der Phaseneinstellung zwischen den beiden Ausgangs-Signalen 10 und 21 auf die Hälfte, also auf 180° n bzw. $\pi$/n zu reduzieren. Dabei wird über den Steueranschluß des Inverters entschieden, ob dieser das Signal fn invertiert oder nicht-invertiert über die Verbindungsleitung 26 an den Zähler 16 weitergibt.

Das niederwertigste Bit (231) des Vorgabewertes 23 wird zu diesem Zweck nicht auf den Komparator 22 sondern auf den Steueranschluß der Invertierung 25 geführt. Zur Gewährung der Halbierung der Schrittweite muß das Taktsignal 4 (Rechteckspannung) dabei ein Impulsverhältnis von 1:1 haben.

In der hier beschriebenen Art können noch beliebig viel weitere digitale Signalgeneratoren mit digitaler Phaseneinstellung angefügt werden.

Abschließend sei noch darauf hingewiesen, daß es sich selbstverständlich bei den in den Figuren 1 und 2 eingezeichneten Leitungen für die Binärworte 7, 12, 18, 23, 27, 28 immer nur um die erste und die letzte Leitung und gegebenenfalls um irgendeine der mittleren Leitungen handelt und daß die Zahl der Leitungen an sich beliebig ist und nur von den speziellen Randbedingungen der betreffenden Anwendungen abhängt.

Es versteht sich, die Erfindung mit fachmännischem Wissen aus- und weitergebildet werden kann bzw. an spezielle Anwendungen angepaßt werden kann, ohne daß dies hier an dieser Stelle näher erläutert werden müßte.

So kann beispielsweise statt eines Magnitude-Komparators 11 bzw. 22 auch eine Anzahl von Exclusiv-Oder-Gattern eingesetzt werden, die die einzelnen Bit-Paare vergleichen. Das Ergebnis muß dann über eine gemeinsame UND-Verknüpfung zusammengefaßt werden.

Weiterhin kann in der RDS-Coder-Anwendung Ausgang 10 das RDS-Signal und Ausgang 21 das Verkehrsfunk-Signal enthalten oder umgekehrt. Schließlich kann die Steuerung der Phasenlagen über die Vorgabeworte 12 und 23 durch einen Computer bzw. Mikroprozessor erfolgen.

**Ansprüche**

1. Anordnung zum Einstellen der Phase eines digitalen generierten Signals mit einem Phasenstellglied, dadurch gekennzeichnet, daß die Einstellung der Phase digital erfolgt.

2. Anordnung nach Anspruch 1, dadurch gekennzeichnet, daß die Phase zwischen 0 und $m \cdot 2\pi$ in Einheiten von $2\pi \cdot n$ oder Bruchteilen davon beliebig einstellbar ist mit m, n gleich ganzen positiven Zahlen und $m \geq 1$ und $n \geq 2$.

3. Anordnung nach Anspruch 2, dadurch gekennzeichnet,
- daß das Phasenstellglied einen Phasenvergleicher (2) und einen in der Phase seines Ausgangssignals (fn) durch den Phasenvergleicher (2) kontrollierten spannungsgesteuerten Oszillator (3) enthält;
- daß der Phasenvergleicher (2) die Phase eines digital generierten Vergleichssignals (D1) mit der eines Referenzsignals (f1) vergleicht und daraus das Phasenkorrektursignal für den spannungsgesteuerten Oszillator (3) ableitet;
- daß ein über eine Verbindungsleitung (13, 15) mit dem Phasenvergleicher (2) verbundener Komparator (11) Binärworte (7) eines ersten Binärzählers (5) mit parallelen Ausgängen (71...75...79) mit einem vorgegebenen Binärwort (12) vergleicht und bei Gleichheit der Worte (7, 12) das Vergleichssignal (D1) generiert;
- daß die Binärworte (12) die vollständige Information über die einzustellende Phase des digital zu generierenden Signals (f2) enthalten;
- daß das Ausgangssignal (fn) des spannungsgesteuerten Oszillators (3) als Taktsignal für den ersten Binärzähler (5) vorgesehen ist und daß das Signal (fn) die n-fache Frequenz des Referenzsignals (f1) besitzt.

4. Anordnung nach Anspruch 3, dadurch gekennzeichnet, daß mindestens eine Periode des digital zu generierenden Signals (f2) in einem digitalen Speicher (8) in Form mehrerer Stützwerte gespeichert ist und über einen Digital-Analog-Wandler (9) auslesbar ist und daß die Parallelausgänge (71...75...79) des ersten Binärzählers (5) zusätzlich mit ersten Adresseneingängen des digitalen Speichers (8) verbunden sind.

5. Anordnung nach Anspruch 4, dadurch gekennzeichnet, daß nur die Parallelausgänge (71...75) des ersten Binärzählers (5) mit den höherwertigen Bits zusätzlich mit den Adresseneingängen des digitalen Speichers (8) verbunden sind.

6. Anordnung nach mindestens einem der Ansprüche 4 bis 5, dadurch gekennzeichnet,
- daß dem ersten Binärzähler (5) ein zweiter Binärzähler (6) mit parallelen Ausgängen (271...279) nachgeschaltet ist;
- daß die Parallelausgänge (271...279) des zweiten Binärzählers (6) mit zweiten Adresseneingängen des digitalen Speichers (8) verbunden sind;
- daß das Binärwort (27) des zweiten Binärzählers (6) Informationen darüber enthält, welche der im digitalen Speicher (8) abgespeicherten Periode(n) des digital zu generierenden Signals (f2) zu generieren ist (sind).

7. Anordnung nach Anspruch 3, dadurch gekennzeichnet, daß bei Synchronisierung des digital zu generierenden Signals (f2) auf eine harmonische Oberschwingung des Referenzsignals (f1) mit der k-fachen Frequenz des Referenzsignals (f1) mit k gleich einer positiven ganzen Zahl größer oder gleich 2 in der Verbindungsleitung (13, 15) zwischen Komparator (11) und Phasenvergleicher (2) ein Frequenzteiler (14) angeordnet ist und daß dieser Frequenzteiler (14) die Frequenz des digital generierten Vergleichssignals (D1) durch k teilt.

8. Anordnung nach mindestens einem der Ansprüche 1 bis 7, dadurch gekennzeichnet, daß mindestens ein weiteres digital generiertes Signal (f3) in seiner Phase digital einstellbar ist.

9. Anordnung nach Anspruch 8, dadurch gekennzeichnet, daß die Phasendifferenz(en) zwischen den einzelnen digital generierten Signalen (f2, f3) zwischen 0 und $p \cdot 2\pi$ in Einheiten von $2\pi \cdot n$ beliebig einstellbar ist mit p, gleich einer ganzen positiven Zahl und $p \geq 1$.

10. Anordnung nach Anspruch 9, dadurch gekennzeichnet,
- daß für jedes weitere digital zu generierende und in seiner Phase digital einstellbare Signal (f3) jeweils ein weiterer Komparator (22) und ein weiterer erster Binärzähler (16) mit parallelen Ausgängen (181...185 198) vorgesehen sind;
- daß jeweils der weitere Komparator (22) die Binärworte (7) des ersten Binärzählers (5) mit einem vorgegebenen weiteren Binärwort (23) vergleicht und bei Gleichheit der Worte (7, 23) ein Vergleichssignal (D2) generiert;

- daß jeweils das Ausgangssignal (fn) des spannungsgesteuerten Oszillators (3) jeweils als Taktsignal für den weiteren ersten Binärzähler (16) vorgesehen ist.

- daß jeweils das Vergleichssignal (D2) des weiteren Komparators (22) den weiteren ersten Binärzähler (16) zurücksetzt oder neu startet;

- daß jeweils das vorgegebene weitere Binärwort (23) die vollständige Information über die einzustellende Phase des zugehörigen weiteren digital zu generierenden Signals (f3) enthält.

11. Anordnung nach Anspruch 10, dadurch gekennzeichnet, daß jeweils mindestens eine Periode des weiteren digital zu generierenden Signals (f3) in einem weiteren digitalen Speicher (19) in Form mehrerer Stützwerte gespeichert ist und über einen weiteren Digital/Analog-Wandler (20) auslesbar ist und daß jeweils die Parallelausgänge (181...185.. 189) des weiteren ersten Binärzählers (16) mit ersten Adresseneingängen des weiteren digitalen Speichers (19) verbunden sind.

12. Anordnung nach Anspruch 11, dadurch gekennzeichnet, daß jeweils nur die Parallelausgänge (181...185) des weiteren ersten Binärzählers (16) mit den höherwertigen Bits mit ersten Adresseneingängen des weiteren digitalen Speichers (19) verbunden sind.

13. Anordnung nach mindestens einen der Ansprüche 10 bis 11, dadurch gekennzeichnet,

- daß jeweils dem weiteren ersten Binärzähler (16) ein weiterer zweiter Binärzähler (17) mit parallelen Aus- gängen (281...289) nachgeschaltet ist;

- daß jeweils die Parallelausgänge (281...289) des weiteren zweiten Binärzählers (17) mit zweiten Adresseneingängen des weiteren digitalen Speichers (19) verbunden sind;

- daß jeweils das Binärwort (28) des weiteren zweiten Binärzählers (17) Informationen darüber enthält, welche der in den weiteren digitalen Speicher (19) abgespeicherten Periode(n) des digital zu generierenden Signals (f3) zu generieren ist (sind).

14. Anordnung nach Anspruch 10, dadurch gekennzeichnet, daß jeweils in die Verbindungsleitung (4, 26) zwischen dem Ausgang des spannungsgesteuerten Oszillators (3) und dem Taktsignaleingang des weiteren ersten Binärzählers (16) ein steuerbarer Inverter (25) angeordnet ist und daß jeweils das niederwertigste Bit (231) des weiteren vorgegebenen Binärwortes (23) an den Steuereingang des Inverters (25) angeschlossen ist und daß jeweils alle anderen Bits des weiteren vorgegebenen Binärwortes (23) an den weiteren Komparator (22) angeschlossen sind.

15. Anordnung nach Anspruch 14, dadurch gekennzeichnet, daß das Ausgangssignal (fn) des spannungsgesteuerten Oszillators (3) ein Rechtecksignal ist mit einem Tastverhältnis von 1:1.

16. Anordnung nach einem der Ansprüche 3 oder 10, dadurch gekennzeichnet, daß die einzelnen Komparatoren (11 bzw. 22) jeweils aus einer Anzahl von Bits der Binärworte (7, 12 bzw. 7, 23) paarweise vergleichenden Exklusiv-Oder-Gattern und einem eingangsseitig mit den Ausgängen dieser Exklusiv-Oder-Gatter verbundenen UND-Gatter bestehen.

17. Anordnung nach einem der Ansprüche 1 bis 16, gekennzeichnet durch die Anwendung in einem Coder.

18. Anordnung nach Anspruch 17, gekennzeichnet durch die Anwendung in einem Verkehrsfunk-Coder.

19. Anordnung nach Anspruch 17, gekennzeichnet durch die Anwendung in einem RDS ("Radio-Daten-System")-Coder.

20. Anordnung nach einem der Ansprüche 1 bis 16, gekennzeichnet durch die Anwendung in einem Generator.

21. Anordnung nach Anspruch 20, gekennzeichnet durch die Anwendung in einer Vorstufe eines Senders.

FIG.1

FIG.2

UL 87/112

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 013 969 (DENNISON) <br> * Insgesamt * | 1-3 | H 03 L 7/08 <br> H 03 L 7/18 <br> H 04 H 1/00 <br> H 03 B 27/00 |
| Y | | 4-13,15 | |
| | --- | | |
| X | PATENT ABSTRACTS OF JAPAN, Band 8, Nr. 21 (E-224)[1458], 28. Januar 1984; & JP-A-58 184 828 (ANRITSU DENKI K.K.) 28-10-1983 <br> * Zusammenfassung * | 1-3 | |
| | --- | | |
| Y | IDEM | 4-13,15 | |
| | --- | | |
| Y | EP-A-0 220 932 (WESTINGHOUSE ELECTRIC) <br> * Spalte 1, Zeile 63 - Spalte 11, Zeile 14; Figuren 1-6 * | 4,5,8-13,15 | |
| | --- | | |
| Y | US-A-3 870 970 (CHIBANA) <br> * Spalte 2, Zeile 11 - Spalte 6, Zeile 2; Figur 3 * | 6,7 | |
| | --- | | |
| A,D | EUROPEAN BROADCASTING UNION, TECH. 3244-E, März 1984, Seiten 1-58, Rudolf Giessmann, Brüssel, BE; "Specifications of the radio data system RDS for VHF/FM sound broadcasting" <br> * Figur 1; Seite 6 * | 17-21 | RECHERCHIERTE SACHGEBIETE (Int. Cl.4) <br><br> H 03 L <br> H 03 D <br> H 03 B <br> H 04 H |
| | --- | | |
| A | US-A-3 571 743 (MENKES) <br> * Figur 3 * | 10 | |
| | --- | | |
| A | GB-A-2 101 825 (SINGER) | | |
| | --- | | |
| A | US-A-4 404 430 (OGITA) | | |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 06-03-1989 | DHONDT I.E.E. |